Europäisches Patentamt

European Patent Office

Office européen des brevets

(19)

(11) Numéro de publication : **0 165 364
B1**

# (12) FASCICULE DE BREVET EUROPÉEN

(45) Date de publication du fascicule du brevet :
**07.09.88**

(21) Numéro de dépôt : **84430020.2**

(22) Date de dépôt : **20.06.84**

(51) Int. Cl.⁴ : **H 01 L 21/66, H 01 L 21/324,
C 30 B 33/00, B 07 C 5/344**

(54) **Procédé de standardisation et de stabilisation de tranches semiconductrices.**

(43) Date de publication de la demande :
**27.12.85 Bulletin 85/52**

(45) Mention de la délivrance du brevet :
**07.09.88 Bulletin 88/36**

(84) Etats contractants désignés :
**DE FR GB**

(56) Documents cités :
**EP-A- 0 020 993
EP-A- 0 058 337
EP-A- 0 090 320
US-A- 4 342 616
Le dossier contient des informations techniques
présentées postérieurement au dépôt de la demande
et ne figurant pas dans le présent fascicule.**

(73) Titulaire : **International Business Machines Corporation
Old Orchard Road
Armonk, N.Y. 10504 (US)
DE GB
Compagnie IBM FRANCE
5 Place Vendôme
F-75000 Paris 1er (FR)
FR**

(72) Inventeur : **Cazcarra, Victor
51, av. de Neufville
F-91540 Mennecy (FR)**
Inventeur : **Leroueille, Jocelyne
13 place A. France
F-91260 Juvisy S/ Orge (FR)**

(74) Mandataire : **Klein, Daniel Jacques Henri
Compagnie IBM France Département de Propriété
Intellectuelle
F-06610 La Gaude (FR)**

EP 0 165 364 B1

Jouve, 18, rue St-Denis, 75001 Paris, France

## Description

Domaine Technique

La présente invention concerne le domaine de la fabrication des tranches semiconductrices, et plus particulièrement, un procédé de standardisation et de stabilisation de tranches semiconductrices, typiquement en silicium, pour les rendre universelles, c'est-à-dire aptes à être traitées indifféremment sur les lignes de fabrication de dispositifs tant bipolaires qu'unipolaires (F.E.T.).

Etat de la Technique Antérieure

Il n'est pas possible d'éliminer totalement la contamination lors de la fabrication des circuits intégrés à semiconducteurs. Pour pallier cet inconvénient, différentes techniques de piégeage des impuretés et autres contaminants ont été développées dans l'art antérieur. Parmi celles-ci figure le piégeage interne par les micro-défauts. Cette propriété, propre au silicium, repose sur la présence d'atomes d'oxygène en solution solide sursaturée dans le silicium. Ces atomes se rassemblent, lors des étapes de traitement thermique ultérieures et précipitent sous la forme de petits agrégats ou précipités. Ce phénomène de précipitation s'accompagne en outre d'une génération de défauts secondaires, tels que fautes d'empilement et/ou boucles de dislocation. L'ensemble de ces microdéfauts (précipités et défauts secondaires) constitue autant de sites préférentiels de diffusion vers lesquels les impuretés et contaminants seront attirés et piégés. L'efficacité du piégeage dépend de la cinétique de précipitation des atomes d'oxygène qui est elle-même fonction de sa concentration initiale et de la distribution des germes de précipitation à l'origine. Jusqu'à ce jour, il ne semble pas que tous ces problèmes aient été parfaitement compris et maîtrisés. Il ressort de la littérature, que trois conditions gouvernent la capacité des tranches à présenter l'effet de piégeage interne désiré :

1. la concentration (ou teneur) d'atomes d'oxygène, qui doit être suffisamment élevée pour que la précipitation puisse se produire ;
2. la présence d'une zone sans défaut à la surface de la face active de la tranche ;
3. la présence de sites de nucléation : petits amas ou agglomérats d'atomes d'oxygène, qui doivent nécessairement pré-exister dans la tranche.

La première condition est considérée comme facilement remplie : en effet, les tranches disponibles commercialement, sont généralement fabriquées selon la méthode de Czochralski et ont pratiquement toutes une concentration d'atomes d'oxygène, comprise dans la gamme désirée de 26 à 40 ppmA. On sait que la fabrication de produits bipolaires requiert des tranches ayant des concentrations comprises de préférence entre 26 et 36 ppmA, tandis que la fabrication des produits unipolaires, requiert des concentrations comprises entre de préférence 30 et 40 ppmA (pour plus de détails, on pourra se référer au brevet US-A-4344815).

En ce qui concerne la seconde condition, on sait que la réalisation d'une zone sans défaut est rendue possible grâce à l'aptitude des atomes d'oxygène à diffuser vers l'extérieur de la tranche (exodiffusion) lors de traitements thermiques à des températures très élevées (T ⩾ 1 000 °C). Selon ce processus, la concentration des atomes d'oxygène se rapproche de la limite de solubilité dans les premiers microns, sous la surface. La solution solide est donc stabilisée, puisque l'on n'est plus en sursaturation. Lors de traitements ultérieurs, la précipitation de l'oxygène se produit dans le volume et non plus en surface, d'où la génération d'une zone sans défaut en surface.

Enfin en ce qui concerne la troisième condition, on sait aussi que la génération de sites de nucléation ou germination, se produit quant à elle, lors d'un traitement thermique à plus basse température (T < 900 °C). Il s'agit cette fois d'un processus qui tend à réduire la sursaturation par la création de petits germes de précipités et qui est gouverné par des fluctuations aléatoires de la concentration.

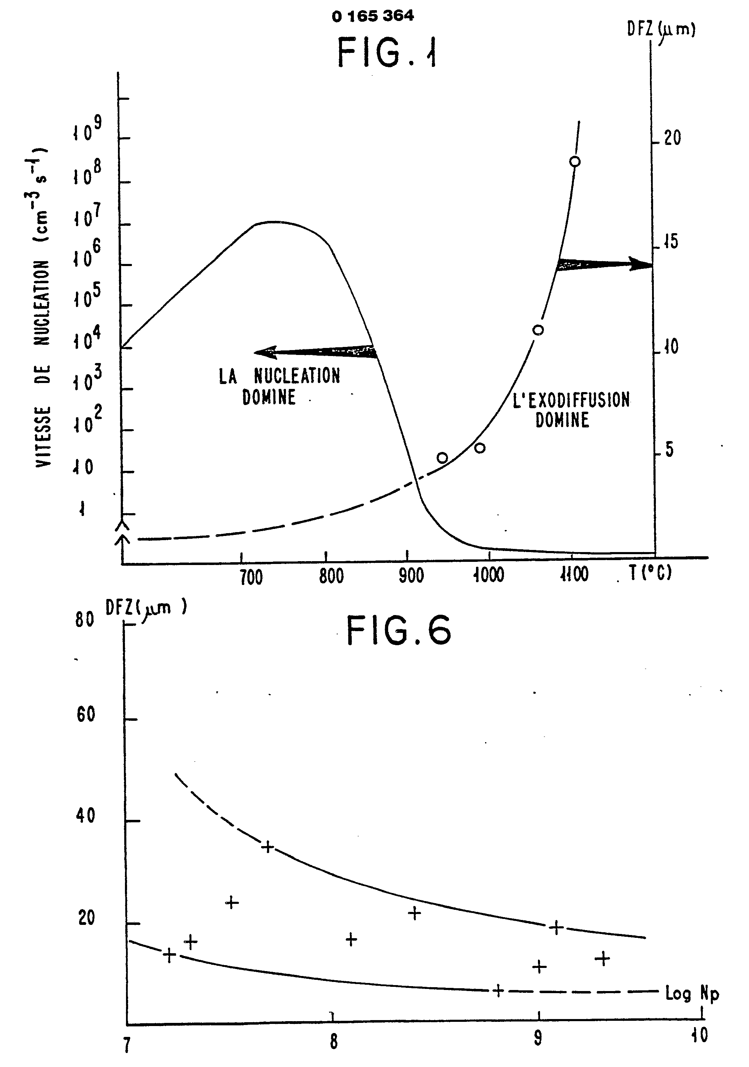

Les deux processus correspondants aux conditions 2 et 3, sont parfaitement explicités par les courbes de la figure 1, qui représentent les variations de la vitesse de nucléation et de la profondeur de la zone sans défaut, en fonction de la température T du traitement thermique.

Diverses tentatives ont été entreprises pour tenter de définir un procédé de fabrication de tranches qui combine ces deux processus. L'ordre des opérations s'est révélé être important lors des expérimentations effectuées par la demanderesse. Selon une première approche qui vise à supprimer les effets des traitements thermiques antérieurs, on procède d'abord au traitement thermique à haute température (par exemple à une température de 1 250 °C). Avec cette opération, on dissout la totalité des germes existants qui avaient été formés lors du refroidissement du barreau après son tirage (ou lors du recuit de stabilisation) et on favorise l'exodiffusion des atomes d'oxygène. Ensuite, on poursuit par un traitement de régénération et de consolidation des sites de nucléation, à une température comprise entre 500 et 900 °C qui reforme une nouvelle distribution des germes. Ce cycle thermique particulier, est pénalisé par les très hautes températures mises en jeu dans sa première partie (~ 1 200 °C).

L'autre approche consiste plutôt à tirer parti de la distribution existante de germes et à l'aménager.

Dans ce cas, on effectue les opérations dans l'ordre inverse. On consolide d'abord une partie des germes déjà présents, par un traitement thermique effectué vers 800-900 °C. Puis, la dissolution des germes proches de la surface et l'exodiffusion de l'oxygène dans cette zone, sont assurées par un second traitement thermique effectué vers 1 000-1 100 °C, donc à une température inférieure à celle qui lui correspond dans le cycle thermique précédent.

Cependant cette dernière approche employée telle quelle, s'est révélée désastreuse, en raison des problèmes posés par les tranches dont le nombre de germes générés est situé dans la queue des courbes de distribution. Pour ces tranches, le piégeage interne peut se révéler (en raison du défaut de stabilisation) soit excessif pour les lignes de fabrication de dispositifs unipolaires, soit insuffisant pour les lignes de fabrication de dispositifs bipolaires.

Il ne semble donc pas possible de procéder à un cycle thermique identique pour toutes les tranches. Il faudrait un traitement thermique qui soit propre à chaque tranche en vue de son application particulière, mais cela impliquerait de gérer un nombre considérable de tranches différentes, pour chaque application.

## Exposé de l'invention

En conséquence, un premier but de l'invention est de définir un procédé de standardisation et de stabilisation des tranches en vue de leur utilisation ultérieure sur les lignes de fabrication de dispositifs tant bipolaires qu'unipolaires.

Un autre but de l'invention est de définir un procédé qui assure aux tranches semiconductrices, un piégeage interne, contrôlé et reproductible et ce quelles que soient leurs caractéristiques initiales.

Encore un autre but de l'invention est de définir un procédé qui accepte des tranches provenant de fournisseurs différents et présentant une très large gamme de concentrations d'oxygène initiales, et permet ainsi une grande souplesse au niveau des approvisionnements.

Conformément à la présente invention, on se fixe à priori le nombre de germes de précipitation et la profondeur de la zone sans défaut dans une gamme que l'on estime optimale. Ensuite, on ne définit pas un traitement unique mais une gamme de traitements, adaptés à des tranches ayant des caractéristiques de précipitation différentes.

Le procédé de la présente invention comporte les étapes suivantes :
— tri des tranches en classes (C1-C3), chaque classe ne contenant que des tranches ayant un taux de précipitation voisin déterminé par la concentration initiale d'oxygène et le nombre initial de germes de nucléation dans la tranche ;
— application d'un cycle thermique d'adaptation identique pour toutes les tranches d'une même classe, de telle sorte qu'une zone sans défaut de 10 $\mu$m à 30 $\mu$m de profondeur soit créée correspondant à un nombre de germes compris entre $2.10^8$ et $2.10^9$ germes/cm$^3$ ; et,
— nettoyage des tranches.

Le cycle thermique d'adaptation mentionné ci-dessus comprend une première étape de germination qui consiste dans un traitement thermique personnalisé pour chaque classe de tranches et une étape de génération de la zone sans défaut et de stabilisation, pratiquement identique pour toutes les tranches.

D'autres buts, caractéristiques, et avantages de la présente invention ressortiront mieux de l'exposé qui suit, fait en référence aux dessins annexés à ce texte, qui représentent un mode de réalisation préféré de celle-ci.

## Brève Description des Figures

La figure 1 représente les courbes de variation de la vitesse de nucléation et de la profondeur de la zone sans défaut (DFZ), en fonction de la température (T) du traitement thermique.

La figure 2 représente un bloc diagramme schématique des différentes étapes qui caractérisent le procédé de la présente invention.

La figure 3 représente les courbes des variations de la quantité d'oxygène précipité en fonction de la température du traitement thermique lors d'un test de précipitation, pour des tranches ayant différentes concentrations en oxygène.

La figure 4 représente la variation de la quantité d'oxygène précipité en fonction de la concentration d'oxygène, pour des tranches de diverses origines.

La figure 5 représente le diagramme du cycle thermique d'adaptation conformément au procédé de la présente invention pour chaque classe.

La figure 6 représente la courbe de la variation de la profondeur de zone sans défaut (DFZ), en fonction du nombre de germes générés.

## Description du Mode Préféré de Réalisation

Selon la présente invention, il s'agit tout d'abord de répartir les tranches en différentes classes. Chaque classe ne contient que des tranches présentant la même distribution initiale de germes. En effet pour standardiser les tranches, il ne serait pas possible, même en annihilant leur histoire thermique,

d'obtenir la même distribution de germes par un traitement thermique unique pour des tranches ayant des concentrations d'oxygène comprises dans une gamme aussi étendue que 26-40 ppmA.

La démarche qui va être décrite est réaliste par le fait qu'il existe maintenant sur le marché des outils de caractérisation permettant de trier aisément les tranches, selon des niveaux de concentrations initiales d'oxygène, sans pour autant dégrader l'état de surface desdites tranches.

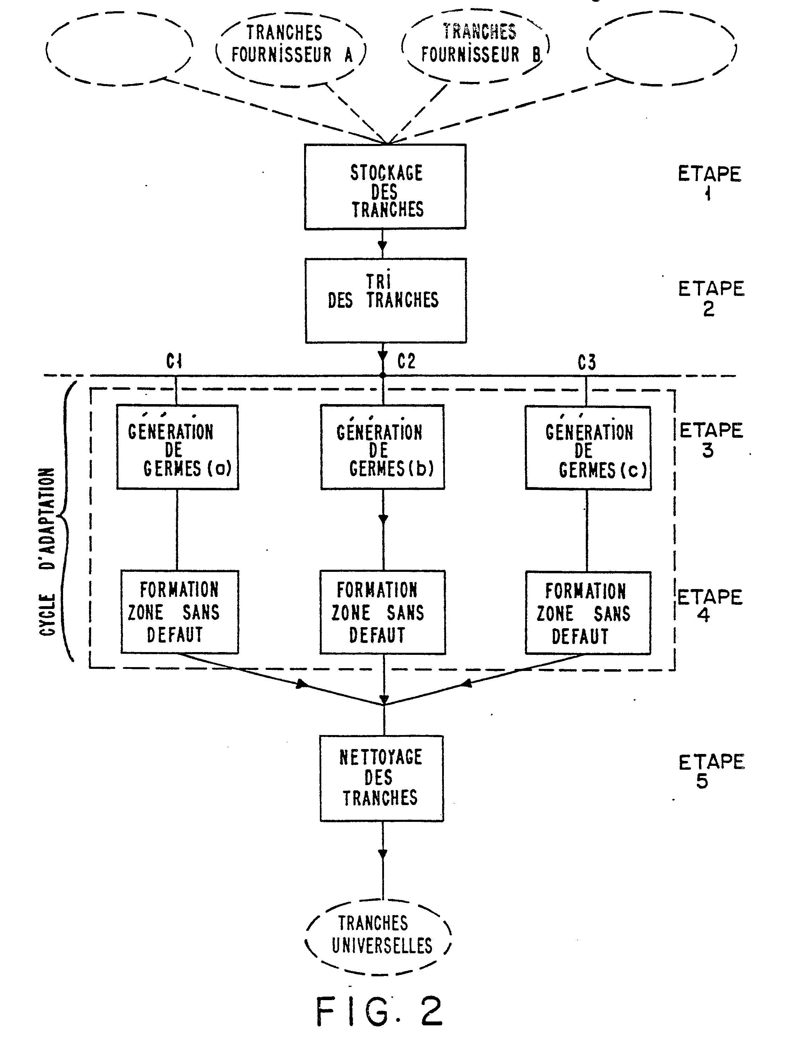

La figure 2 représente le bloc diagramme schématique des différentes étapes du procédé de standardisation et de stabilisation de la présente invention.

Dans la description qui va suivre les tranches qui seront traitées, seront des tranches de silicium provenant de 2 vendeurs appelés A et B, dont on sait seulement que leur teneur en oxygène est comprise approximativement entre 26 et 40 ppmA. L'unité ppmA (part per million atomic) correspond à $0,5 \times 10^{17}$ atomes d'oxygène par $cm^3$ de silicium.

Les tranches sont stockées après réception, mais gardent l'indication du vendeur d'origine (étape 1).

Comme cela a été dit ci-dessus, la cinétique de précipitation de l'oxygène est déterminée par deux paramètres : la concentration initiale d'oxygène et le nombre de germes de nucléation présents dans la tranche à l'instant initial. La détermination de ces paramètres, et le tri des tranches selon leur taux de précipitation, fait l'objet de l'étape 2, qui va être maintenant décrite en détail.

Le premier paramètre est mesuré directement par spectrométrie d'absorption infra-rouge en utilisant la norme classique de Baker.

$$[0]_{ppmA} = 9.63 \, \alpha_{cm^{-1}}$$

où $\alpha$ est le coefficient d'absorption à 9 $\mu$m.

Les mesures sont faites sur toutes les tranches stockées et, très rapidement, afin de ne pas dégrader leur état de surface.

On a trouvé que les concentrations initiales en oxygène des tranches fournies par les vendeurs A et B étaient respectivement comprises entre 30-39 ppmA et 27-36 ppmA.

Les tranches fournies par un même vendeur et présentant des concentrations initiales en oxygène voisine sont rassemblées dans un même lot. Par exemple, la répartition selon la gamme suivante de concentrations initiales : 27-30, 30-33, 33-36 et 36-39 ppmA, a semblé être appropriée.

Le second paramètre ne peut pas être déterminé par une mesure directe, il est donc nécessaire de recourir à un traitement thermique, appelé test de précipitation, pour faire précipiter l'oxygène sur les germes existants. Nous utiliserons la quantité d'atomes d'oxygène qui a précipité comme approximation du nombre de germes. En fait, ce nombre peut être réellement calculé à partir de cette quantité.

Il est important de comprendre que ce test de précipitation n'est effectué que sur des tranches échantillons prises dans chacun des lots qui viennent d'être constitués après la caractérisation en spectroscopie I.R.

Deux critères imposent le choix de la température du test de précipitation :

— la température doit être suffisamment élevée pour qu'il n'y ait pas ou peu de germination lors de ce traitement ;

— par contre, elle ne doit pas être trop élevée pour ne pas dissoudre les germes trop petits.

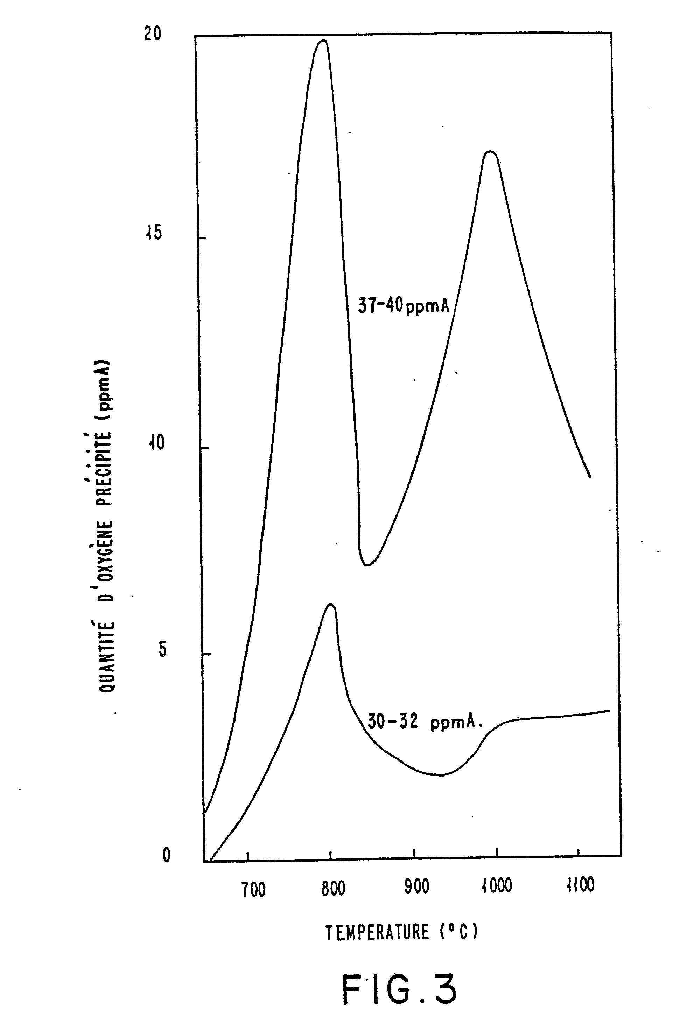

La figure 3 représente les courbes de variation de la quantité d'atomes d'oxygène qui a précipité en fonction de la température du traitement thermique pour des tranches ayant des concentrations différentes en oxygène.

Compte tenu de ces courbes, une température voisine de 900 °C (qui est intermédiaire entre les températures de germination et de précipitation proprement dites) est un choix valable. Une première solution consiste dans un cycle thermique comportant un traitement monotherme à 900 °C d'une durée supérieure à 20 heures, dans une atmosphère d'azote.

Cependant, bien que donnant entière satisfaction, la durée de ce cycle est beaucoup trop longue, d'un point de vue pratique. Un traitement en deux parties, plus rapide, mais aussi plus précis, a donc été défini. Un premier traitement thermique à 900 °C, amène les germes à une taille suffisante, puis un second traitement thermique à 1 100 °C fait précipiter les atomes d'oxygène sur ces germes. L'avantage est, que l'on obtient une variation de la concentration d'oxygène plus aisément détectable. L'oxygène précipité a une bande d'absorption différente de l'oxygène en solution. On détermine la quantité d'oxygène précipitée à partir de la différence de niveaux de la bande d'absorption de l'oxygène en solution, avant et après le test de précipitation.

Le test de précipitation préféré et, finalement retenu au vu de ces considérations, sera donc le cycle thermique suivant :

900 °C pendant 2 heures, puis
1 100 °C pendant 8 heures

dans une atmosphère d'azote.

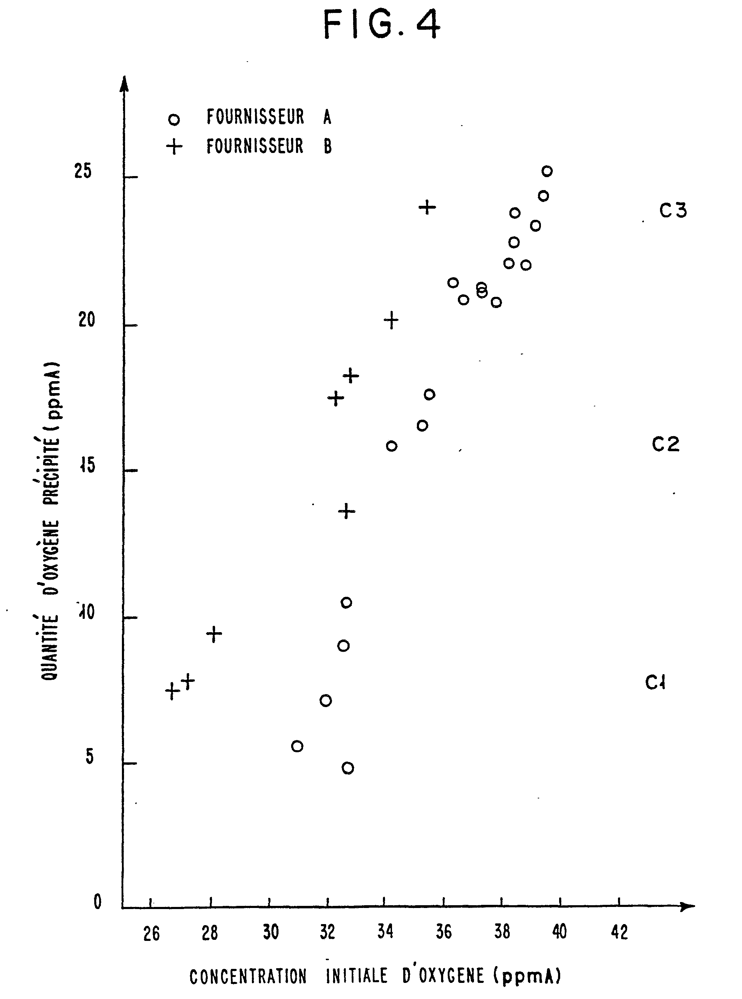

La figure 4 représente les variations de la quantité d'oxygène précipité, en fonction de la concentration initiale d'oxygène pour les tranches échantillons. Ces tranches ont été réparties en trois classes selon la quantité d'oxygène précipité :

C1 : faible taux de précipitation (~ 0-10 ppmA)
C2 : taux de précipitation moyen (~ 10-20 ppmA)
C3 : fort taux de précipitation (> 20 ppmA)

A noter qu'une répartition, plus fine ou légèrement différente de la gamme 26-39 ppmA peut se concevoir.

Les tranches échantillons ayant participé au test de précipitation sont alors éliminées. Les différents lots constitués ci-dessus sont répartis selon ces trois classes à l'aide des enseignements fournis par la figure 4. On obtient alors la table I ci-dessous :

Table I

| CLASSES SELON TAUX DE PRECIPITATION | ORIGINE (VENDEUR) | LOTS SELON CONCENTRATION INITIALE D'ATOMES D'OXYGENE (ppmA) |
|---|---|---|
| C1 | A | 30-33 |
| | B | 27-30 |
| C2 | A | 33-36 |
| | B | 30-33 |
| C3 | A | 36-39 |
| | B | 33-36 |

En conclusion, à la fin de l'étape 2 de la figure 2, toutes les tranches fournies par les vendeurs A et B, après avoir été préalablement réparties en différents lots, selon leur concentration initiale d'oxygène à l'issue de la mesure en spectroscopie IR mentionnée précédemment, sont donc réparties en trois classes (C1-C3) selon leur taux de précipitation.

Une classe peut contenir des tranches présentant des concentrations initiales en oxygène différentes, mais dont on est sûr qu'elles auront un comportement pratiquement identique en ce qui concerne la précipitation à 900 °C, en d'autres termes parce qu'elles ont une distribution initiale de germes trois voisine, les unes des autres.

Pour traiter des tranches provenant d'autres vendeurs que ceux présentés, il suffit de faire subir ledit test de précipitation à des tranches échantillons et de les séparer en classes comme indiqué plus haut. De plus, le test sera fait périodiquement sur des tranches échantillons, pour prendre en compte d'éventuels changements de procédé opérés par les vendeurs et susceptibles d'affecter la cinétique de précipitation.

Pour conclure, dans la pratique, il suffira de connaître l'origine des tranches (ex. A ou B) et leur concentration initiale d'oxygène pour déterminer la classe (C1-C3) d'appartenance. Le test de précipitation effectué sur des tranches échantillons n'a pour objet que de se garantir d'éventuelles dérives dans le procédé de tirage du vendeur.

Conformément au but principal de la présente invention qui est de fournir des tranches stabilisées (ayant des propriétés identiques) et standardisées, aux lignes de fabrication, on se fixe au préalable comme spécifications, une profondeur de zone sans défaut, et donc un nombre de germes qui seront les mêmes pour toutes les tranches. Compte tenu de la technologie, il semble raisonnable d'obtenir une zone sans défaut d'au moins 10 $\mu$m de profondeur (de 10 à 30 $\mu$m par exemple). Ceci permet alors de fixer le nombre de germes dans la gamme de $2 \times 10^8$ à $2 \times 10^9$ germes/cm$^3$, et de préférence à environ $5 \times 10^8$ germes/cm$^3$, soit environ un germe tous les 10 $\mu$m. La présente invention propose un cycle thermique, dit d'adaptation parce qu'adapté à chaque classe de tranches, qui permet d'assurer que toutes les tranches seront conformes aux spécifications sus mentionnées avant d'être livrées aux lignes de fabrication.

5

Ce cycle d'adaptation comporte deux étapes : une étape de génération de germes (germination) et une étape de formation de la zone sans défaut et de consolidation des germes qui sont respectivement référencées 3 et 4 sur la figure 2.

Table II

| CLASSE | C1 | C2 | C3 |
|---|---|---|---|
| TEMPERATURE D'INSERTION | 800°C | 850°C | 900°C |
| TRAITEMENT THERMIQUE | Montée en température jusqu'à 900°C en 26 min. | Montée en température jusqu'à 900°C en 13 min. | Monotherme pendant 12 min. |
| ATMOSPHERE | $O_2$ sec 10 min. puis $O_2$ sec + 1% HCl | $O_2$ sec 10 min. puis $O_2$ sec + 1% HCl | $O_2$ sec 10 min. puis $O_2$ sec + 1% HCl |

En ce qui concerne l'étape 3, les conditions opératoires sont précisées dans la table II. Pour chacune des classes C1 à C3, on notera que la température de traitement initiale est comprise entre 800 et 900 °C. Les durées de traitement indiquées dans la table II sont des valeurs optimisées mais restent cependant indicatives.

Cette étape peut être effectuée dans un four programmable. On remarque que l'étape 3 est personnalisée pour chaque classe, elle est donc différente pour chacune des classes C1, C2, ...

La formation de la zone sans défaut et la consolidation des germes sont obtenues lors de l'étape 4 qui à la différence de l'étape 3, est identique pour toutes les tranches, quelle que soit leur classe d'appartenance. La formation de la zone sans défaut nécessite un traitement thermique d'environ 90 mn, effectué à une température comprise entre 1 050 et 1 200 °C, de préférence à 1 100 °C dans une atmosphère gazeuse appropriée. Ce traitement a été défini ainsi car il correspond à une longueur de diffusion ($\sqrt{Dt}$) de l'ordre des 10 μm visés. La montée en température du four qui passe de 900 °C (température du four à la fin de l'étape 3) à 1 100 °C constitue la partie consolidation des germes proprement dite, qui assurera ultérieurement la stabilisation désirée des tranches. Cette montée en température est effectuée en 30 min dans une atmosphère d'oxygène sec contenant 1 % d'HCl.

Le traitement thermique à 1 100 °C qui permet la formation de la zone sans défaut (DFZ) en assurant l'exodiffusion de l'oxygène s'effectue en fait dans deux atmosphères différentes : d'abord 30 min dans de l'oxygène sec contenant 1 % d'HCl (pour faire croître suffisamment d'oxyde sur les tranches), puis 60 min dans un mélange de $N_2/O_2/HCl$ dans les proportions suivantes en pourcentage : 97,5/1,5/1.

L'étape 4 s'achève par une descente en température de 1 100 °C à 900 °C en 40 min qui s'effectue en deux temps : dans l'atmosphère précitée de $N_2/O_2/HCl$ jusqu'à 1 000 °C puis, dans une atmosphère de $N_2$ seul jusqu'à la sortie des tranches à 900 °C. Cette descente en température doit être conduite avec soin pour éviter tout risque de gaufrage des tranches.

Le choix des atmosphères gazeuses s'est révélé très délicat. En effet, à 1 100 °C, les risques de contamination ne sont pas négligeables et c'est de plus une température où la génération de fautes d'empilement de surface, est maximale. La demanderesse a procédé à divers essais et a retenu les mélanges sus-mentionnés et en particulier le mélange gazeux précité : $N_2/O_2/HCl$ dans les proportions indiquées.

Cette atmosphère particulière a permis de garder un état de surface ne présentant que de rares défauts d'empilement et de faibles dimensions sur une couronne périphérique de moins d'un mm.

La table III résume les traitements thermiques qui constituent l'étape 4, et qui sont identiques quelle que soit la classe.

Table III

| TEMPERATURE D'INSERTION | 900°C |
|---|---|
| TRAITEMENT THERMIQUE | 1. montée en température jusqu'à 1100°C en 30 min. <br> 2. palier monotherme à 1100°C pendant 30 min. <br> 3. palier monotherme à 1100°C pendant 60 min. <br> 4. descente à 1000°C en 20 min. <br> 5. descente à 900°C en 20 min. |
| ATMOSPHERE | 1 et 2. $O_2$ sec + 1% HCl <br> 3 et 4. $N_2/O_2/HCl$ dans les proportions de 97,5/1,5/1 <br> 5. $N_2$ |

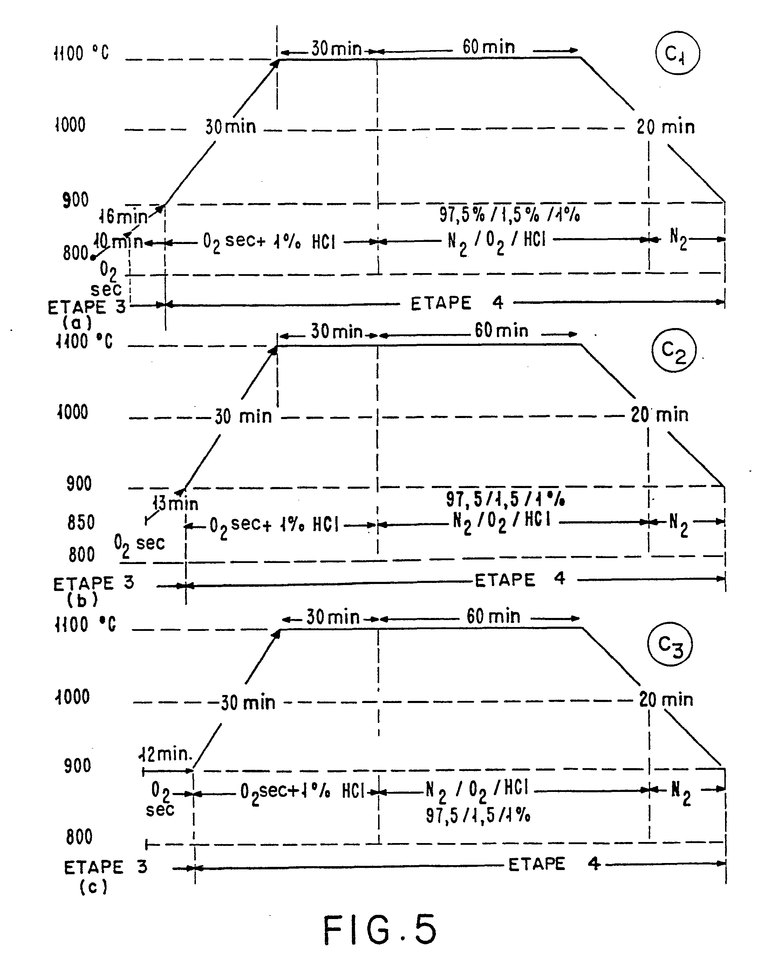

La figure 5 montre le diagramme du cycle thermique d'adaptation, pour chacune des trois classes.

Les tranches sont finalement nettoyées (étape 5, figure 2). Les tranches sont successivement trempées dans une solution diluée d'HF, dans de l'eau désionisée, dans de l'eau de Javel (pour rendre les tranches hydrophiles), de nouveau dans de l'eau désionisée et enfin dans une solution de Huang. Les tranches sont alors stockées, sous la forme de tranches universelles, propres à être utilisées tant sur les lignes de fabrication de dispositifs bipolaires qu'unipolaires. Non seulement ces tranches contiennent le nombre désiré et consolidé de petits amas (noyaux de précipités d'oxygène) mais il en résulte qu'elles sont stabilisées, c'est-à-dire qu'elles seront moins sensibles à d'éventuelles variations du procédé de fabrication.

Un avantage certain du présent procédé est qu'il s'adapte à chaque tranche quelle que soit son origine et/ou ses caractéristiques, les approvisionnements auprès des différents fournisseurs sont donc rendus plus souples et plus économiques.

On notera à ce sujet que si dans la présente description, nous n'avons considéré que le cas des tranches présentant des concentrations initiales d'oxygène comprises dans la gamme standard 26-40 ppmA, on peut envisager cependant un traitement approprié pour des tranches qui présenteraient des concentrations initiales d'oxygène en dehors de cette gamme. Dans le cas, où la concentration d'oxygène est supérieure à 40 ppmA, le nombre de germes est tel à l'état initial, que l'on pourra simplement supprimer l'étape 3 de germination pour ne garder que l'étape 4 de formation de la zone sans défaut et consolidation des germes (l'insertion se fera à 900 °C).

Dans le cas où la concentration d'oxygène est inférieure à 26 ppmA, l'étape 3 de germination doit être poursuivie plus longtemps, par exemple 60 min au lieu de 26 min comme dans l'étape 3 (a) de la figure 5. L'étape 4 n'est pas modifiée.

Pour nous assurer que les buts qui ont été définis plus haut ont été atteints, diverses caractérisations portant sur différents paramètres ont été effectuées expérimentalement :

— caractérisation de l'état de surface :

mesure de l'épaisseur d'oxyde et de sa variation d'épaisseur par ellipsométrie : les tranches obtenues présentaient une épaisseur d'oxyde comprise entre 109,7 et 116, 4 nm avec un $\Delta e$ variant entre 0,7 et 1,7 nm suivant la place des tranches dans la nacelle.

révélation de surface au Wright-Etch après désoxydation : aucun problème de surface n'a été mis en évidence, excepté les quelques fautes d'empilement mentionnées plus haut.

inspection visuelle avant et après désoxydation : les tranches traitées sont conformes aux spécifications les plus sévères sur l'état de surface.

— caractérisation de la déformation plastique :

des mesures de bombé, initiale et finale, ont montré qu'il n'y avait pas de déformation plastique des tranches au cours du cycle (gaufrage).

par topographie aux rayons X, il n'a pas été détecté de lignes de dislocation, excepté dans certains cas, près des points d'ancrage de nacelle dus à un chargement défectueux.

— mise en évidence de la stabilisation de la solution d'oxygène :

Si la solution d'oxygène était modifiée, un traitement thermique à 750 °C provoquerait une variation de résistivité due à la génération de germes ayant un caractère donneur. Un tel traitement, appliqué pendant 20 heures aux tranches traitées conformément à la présente invention n'a entraîné aucune variation de résistivité. Ce résultat démontre bien une stabilisation de la solution.

— détermination du nombre de germes générés :

Après traitement, la variation de la concentration d'oxygène des tranches, est minime. Nous avons donc eu recours à un traitement thermique de précipitation, pendant 24 heures à 1 050 °C, pour provoquer une précipitation notable sur les germes stabilisés. De la connaissance de la quantité d'oxygène précipité, nous avons calculé le nombre de germes de précipitation en utilisant la formule suivante déduite de la loi de Ham (F.S. Ham, JAP 30, 1518, 1959).

$$Np = 2,3 \; 10^{-4} \; D^{-3/2} \; \tau^{-3/2} \; C^{-1/2} \text{ particules/cm}^3$$

avec : D est le coefficient de diffusion de l'oxygène à 1 050 °C, C est la concentration résiduelle d'oxygène, $\tau$ est le temps d'incubation du processus de précipitation qui est donné par la formule suivante :

$$\tau = \frac{t}{\mathrm{Log} \; \dfrac{C_0 - C_L}{C - C_L}}$$

dans laquelle : $C_0$ est la concentration initiale d'oxygène ; $C_L$ est la limite de solubilité à la température considérée (ici $C_L = 8$ ppmA) ; et, t est la durée du traitement.

Nous avons calculé le nombre de germes générés pour des tranches appartenant aux trois classes après avoir subi le cycle thermique complet. La table IV suivante, montre un exemple des résultats obtenus sur quelques échantillons.

Table IV

| CLASSES | $C_0$ (ppmA) | C (ppmA) | $Np$ ($10^8$ .cm$^{-3}$) |
|---------|---------|---------|---------|
|    | 28.6 | 20.0 | 6.3 |
| C1 | 29.5 | 21.9 | 4.7 |
|    | 29.7 | 21.7 | 4.7 |
|    | 31.2 | 22.5 | 4.4 |
| C2 | 31.8 | 22.7 | 4.6 |
|    | 32.6 | 21.8 | 6.4 |
|    | 33.5 | 23.5 | 2.4 |
| C3 | 34.0 | 19.2 | 5.8 |
|    | 35.7 | 18.8 | 7.0 |

Il faut remarquer que ces valeurs théoriques ont été confirmées quant à l'ordre de grandeur, par le décompte des piqûres d'attaque (etch pits) après polissage puis révélation chimique.

— caractérisation de la profondeur de zone sans défaut :

Nous avons utilisé la technique du biseau, c'est-à-dire la révélation chimique (au Wright-etch) sur les tranches ayant été repolies en biseau sur une section. Nous avons fait cette caractérisation sur les tranches ayant subi le traitement thermique de 24 heures à 1 050 °C, car les défauts obtenus juste après le prérecuit ne sont pas suffisamment gros pour être visualisés. La courbe présentée sur la figure 6, montre la variation de la zone sans défaut en fonction du nombre de germes générés Np. Ainsi que nous le voyons, pour la gamme de germes considérée, on obtient une profondeur de zone sans défaut d'au moins 10 μm.

— Caractérisation électrique de la zone sans défaut (test MOS) :

La réalisation d'une capacité MOS et l'étude de sa réponse transitoire lorsqu'on fait passer la capacité, brutalement du mode d'accumulation au mode d'inversion, permet d'apprécier la qualité électrique des premiers microns sous la surface. Avec cette méthode, nous n'avons pas détecté de problèmes particuliers sur les tranches prétraitées. Le test d'une telle structure réalisée sur une tranche repolie en biseau montre une dégradation de la durée de vie des porteurs vers le cœur de la tranche ce qui est bien le signe de la présence d'un gradient de défauts.

**0 165 364**

**Revendications**

1. Procédé de standardisation et de stabilisation de tranches semiconductrices en silicium provenant de vendeurs différents (A, B, ...) pour les rendre aptes à être traitées sur des lignes de fabrication tant de dispositifs bipolaires que de dispositifs unipolaires caractérisé en ce qu'il comporte les étapes suivantes :
— tri des tranches en classes (C1-C3), chaque classe ne contenant que des tranches ayant un taux de précipitation voisin déterminé par la concentration initiale d'oxygène et le nombre initial de germes de nucléation dans la tranche ;
— application d'un cycle thermique d'adaptation identique pour toutes les tranches d'une même classe, de telle sorte qu'une zone sans défaut de 10 $\mu$m à 30 $\mu$m de profondeur soit créée correspondant à un nombre de germes compris entre $2.10^8$ et $2.10^9$ germes/$cm^3$ ; et,
— nettoyage des tranches.

2. Procédé selon la revendication 1 caractérisé en ce que ladite étape de tri comporte une étape initiale qui consiste à répartir les tranches en différents lots, chaque lot comportant des tranches fournies par un même vendeur et présentant des concentrations initiales en oxygène voisines.

3. Procédé selon la revendication 2 caractérisé en ce que la répartition des tranches s'effectue selon la gamme suivante < 26 ; 27-30 ; 30-33 ; 33-36 ; 36-39 ; et > 40 ppmA.

4. Procédé selon la revendication 3 caractérisé en ce que pour les tranches dont la concentration en oxygène est comprise entre 26 et 40 ppmA, le taux de précipitation est déterminé par un test de précipitation consistant dans un traitement monotherme à 900 °C pendant une durée supérieure à 20 heures dans une atmosphère d'azote, de tranches échantillons prises dans chaque lot.

5. Procédé selon la revendication 3 caractérisé en ce que pour les tranches dont la concentration en oxygène est comprise entre 26 et 40 ppmA, le taux de précipitation est déterminé par un test de précipitation consistant dans un traitement à 900 °C pendant 2 heures suivi d'un traitement à 1 100 °C pendant 8 heures sous atmosphère d'azote, de tranches échantillons prises dans chaque lot.

6. Procédé selon la revendication 4 ou 5 caractérisé en ce que ledit cycle thermique d'adaptation comporte une étape de germination à une température comprise entre 800 et 900 °C et une étape de formation de la zone sans défaut à une température comprise entre 1 050 et 1 250 °C.

7. Procédé selon la revendication 6 caractérisé en ce que l'étape de germination comporte les traitements suivants :

| | C1 | C2 | C3 |
|---|---|---|---|
| TEMPERATURE D'INSERTION | 800°C | 850°C | 900°C |
| TRAITEMENT THERMIQUE | Montée en température jusqu'à 900°C en 26 mn | Montée en température jusqu'à 900°C en 13 min. | Monotherme pendant 12 min. |
| ATMOSPHERE | $O_2$ sec 10 mn puis $O_2$ sec + 1% HCl | $O_2$ sec 10 mn puis $O_2$ sec + 1% HCl | $O_2$ sec 10 mn puis $O_2$ sec + 1% HCl |

8. Procédé selon la revendication 6 ou 7 caractérisé en ce que l'étape de formation de la zone de défauts et de consolidation des germes comporte les traitements suivants :

| TEMPERATURE D'INSERTION | 900°C |
|---|---|
| TRAITEMENT THERMIQUE | 1. montée en température jusqu'à 1100°C en 30 min. 2. palier monotherme à 1100°C pendant 30 min. 3. palier monotherme à 1100°C pendant 60 min. 4. descente à 1000°C en 20 min. 5. descente à 900°C en 20 min. |

9

**0 165 364**

Tableau (Suite)

| TEMPERATURE D'INSERTION | 900°C |
|---|---|
| ATMOSPHERE | 1 et 2. $O_2$ sec + 1% HCl<br>3 et 4. $N_2/O_2/HCl$ dans les proportions 97,5/1,5/1<br>5. $N_2$ |

9. Procédé selon la revendication 3 caractérisé en ce que pour les tranches qui ont une concentration initiale d'oxygène supérieure à 40 ppmA, ledit cycle thermique d'adaptation comporte seulement l'étape de formation de la zone sans défaut et de consolidation des germes à une température comprise entre 1 050 et 1 200 °C.

10. Procédé selon la revendication 9 caractérisé en ce que pour les tranches qui ont une concentration initiale d'oxygène inférieure à 26 ppmA, ledit cycle thermique d'adaptation comporte une étape de germination à une température comprise entre 800 et 900° et pendant une durée d'environ 1 heure, et une étape de formation de la zone sans défaut et de consolidation des germes à une température comprise entre 1 050 et 1 200 °C.

11. Procédé selon la revendication 9 ou 10 caractérisé en ce que ladite étape de formation de la zone sans défaut et de consolidation des germes comporte le cycle suivant :

| TEMPERATURE D'INSERTION | 900°C |
|---|---|
| TRAITEMENT THERMIQUE | 1. montée en température jusqu'à 1100°C en 30 min.<br>2. palier monotherme à 1100°C pendant 30 min.<br>3. palier monotherme à 1100°C pendant 60 min.<br>4. descente à 1000°C en 20 min.<br>5. descente à 900°C en 20 min. |
| ATMOSPHERE | 1 et 2. $O_2$ sec + 1% HCl<br>3 et 4. $N_2/O_2/HCl$ dans les proportions 97,5/1,5/1<br>5. $N_2$ |

**Claims**

1. A method of standardizing and stabilizing semiconductor wafers of silicon supplied by different vendors (A, B, ...) so that they can be used on both unipolar and bipolar device production lines, characterized in that it includes the steps of :

— sorting the wafers into classes (C1-C3) each of which only comprises wafers exhibiting fairly similar precipitation rates determined by the initial oxygen concentration and the initial number of nucleation clusters in the wafer ;

— subjecting all wafers within the same class to the same thermal adaptation cycle to form a defect-free zone 10 μm to 30 μm in depth corresponding to a number of clusters in the range of $2 \times 10^8$ to $2 \times 10^9$ clusters/cm³ ; and

— cleaning the wafers.

2. A method according to claim 1, characterized in that said sorting step includes an initial step of sorting the wafers into different lots comprised each of wafers supplied by the same vendor and exhibiting fairly similar initial oxygen concentrations.

3. A method according to claim 2, characterized in that said lots comprise wafers whose initial oxygen concentrations are in the following ranges : < 26 ppmA ; 27-30 ppmA ; 30-33 ppmA ; 33-36 ppmA ; 36-39 ppmA ; and > 40 ppmA.

4. A method according to claim 3, characterized in that the precipitation rate of wafers whose oxygen content is in the range of 26 to 40 ppmA is determined by subjecting sample wafers from each lot to a

10

precipitation test comprising a thermal treatment at 900 °C for a period of time exceeding 20 hours in a nitrogen atmosphere.

5. A method according to claim 3, characterized in that the precipitation rate of wafers whose oxygen content is in the range of 26 to 40 ppmA is determined by subjecting sample wafers from each lot to a precipitation test comprising a 2-hour treatment at 1 100 °C in a nitrogen atmosphere.

6. A method according to claim 4 or 5, characterized in that said thermal adaptation cycle includes a step performed at a temperature in the range of 800 °C to 900 °C to generate clusters and a step performed at a temperature in the range of 1 050 °C to 1 250 °C to form the defect-free zone.

7. A method according to claim 6, characterized in that the cluster generating step comprises the following treatments :

| CLASS | C1 | C2 | C3 |
|---|---|---|---|
| INITIAL TEMPERATURE | 800°C | 850°C | 900°C |
| THERMAL TREATMENT | Increase temperature to 900°C in 26min | Increase temperature to 900°C in 13min | Maintain 900°C for 12min |
| ATMOSPHERE | Dry $O_2$ for 10min, then dry $O_2$ + 1% HCl | Dry $O_2$ for 10min, then dry $O_2$ + 1% HCl | Dry $O_2$ for 10min, then dry $O_2$ + 1% HCl |

8. A method according to claim 6 or 7, characterized in that the step of forming the defect-free zone and of consolidating the clusters comprises the following treatments :

| INITIAL TEMPERATURE | 900°C |
|---|---|
| THERMAL TREATMENT | 1. Increase temperature to 1100°C in 30 min.<br>2. Maintain temperature at 1100°C for 30 min.<br>3. Maintain temperature at 1100°C for 60 min.<br>4. Decrease temperature to 1000°C in 20 min.<br>5. Decrease temperature to 900°C in 20 min. |
| ATMOSPHERE | 1 and 2 : dry $O_2$ + 1% HCl<br>3 and 4 : $N_2/O_2/HCl$ in proportions of 97,5/1,5/1<br>5 : $N_2$ |

9. A method according to claim 3, characterized in that, in the case of wafers whose initial oxygen concentration exceeds 40 ppmA, said thermal adaptation cycle only comprises the step performed at a temperature in the range of 1 050 °C and 1 200 °C to form the defect-free zone and to consolidate the clusters.

10. A method according to claim 9, characterized in that, in the case of wafers whose initial oxygen concentration is less than 26 ppmA, said thermal adaptation cycle comprises a step performed at a temperature in the range of 800 °C to 900 °C for approximately one hour to generate clusters, and a step performed at a temperature in the range of 1 050 °C to 1 200 °C to form the defect-free zone and to consolidate the clusters.

11. A method according to claim 9 or 10, characterized in that said step of forming the defect-free zone and consolidating the clusters comprises the following cycle :

| INITIAL TEMPERATURE | 900°C |
|---|---|
| THERMAL TREATMENT | 1. Increase temperature to 1100°C in 30 min.<br>2. Maintain temperature at 1100°C for 30 min.<br>3. Maintain temperature at 1100°C for 60 min.<br>4. Decrease temperature to 1000°C in 20 min.<br>5. Decrease temperature to 900°C in 20 min. |
| ATMOSPHERE | 1 and 2 : dry $O_2$ + 1% HCl<br>3 and 4 : $N_2/O_2$/HCl in proportions of 97,5/1,5/1<br>5 : $N_2$ |

**Patentansprüche**

1. Verfahren für die Standardisierung und Stabilisierung von Halbleiterscheiben aus Silizium verschiedener Verkäufer (A, B, ...), um sie für die Bearbeitung auf Herstellungsanlagen sowohl zweipoliger als auch einpoliger Vorrichtungen geeignet zu machen, dadurch gekennzeichnet, dass es folgende Schritte enthält :

— Sortierung der Scheiben in Klassen (C1-C3), wobei jede Klasse nur Scheiben mit nahe aneinanderliegenden Fällungsverhältnissen enthält, bestimmt durch die anfängliche Sauerstoffkonzentration und die anfängliche Anzahl Kernbildungskeime in der Scheibe ;

— Anlegen eines gleichen Wärmeanpassungszyklus für alle Scheiben einer gleichen Klasse, sodass eine fehlerfreie Zone von 10 μm bis 30 μm Tiefe erzeugt wird, welche einer Anzahl Keime von $2.10^8$ und $2.19^9$ Keime/cm³ entspricht ; und

— Reinigung der Scheiben.

2. Verfahren gemäss Anspruch 1, dadurch gekennzeichnet, dass der besagte Sortierschritt einen ersten Schritt enthält, der daraus besteht, die Teile in verschiedene Lose aufzuteilen, wobei jedes Los Scheiben eines gleichen Lieferanten mit nahe aneinanderliegenden anfänglichen Sauerstoffkonzentrationen aufweist.

3. Verfahren gemäss Anspruch 2, dadurch gekennzeichnet, dass die Aufteilung der Scheiben nach folgender Palette vorgenommen wird : < 26 ; 27-30 ; 30-33 ; 33-36 ; 36-39 ; und > 40 ppmA.

4. Verfahren gemäss Anspruch 3, dadurch gekennzeichnet, dass für Scheiben, deren Sauerstoffkonzentration 26 bis 40 ppmA beträgt, der Fällungssatz durch einen Fällungstest ermittelt wird, der aus einer Behandlung der jedem Los entnommen Musterscheiben mit einer einheitlichen Temperatur von 900 °C während einer Dauer von über 20 Stunden in Stickstoffatmosphäre besteht.

5. Verfahren gemäss Anspruch 3, dadurch gekennzeichnet, dass für die Abschnitte, deren Sauerstoffkonzentration 26 bis 40 ppmA beträgt, der Fällungssatz durch einen Fällungstest ermittelt wird, der aus einer zweistündigen Behandlung der jedem Los entnommenen Musterscheiben bei 900 °C mit anschliessender 8-stündiger Behandlung bei 1 100 °C unter Stickstoffatmosphäre besteht.

6. Verfahren gemäss Anspruch 4 oder 5, dadurch gekennzeichnet, dass besagter Wärmeanpassungszyklus einen Keimschritt in einer Temperatur von 800 bis 900 °C enthält, und einen Schritt der Bildung der fehlerfreien Zone von 1 050 bis 1 250 °C.

7. Verfahren gemäss Anspruch 6, dadurch gekennzeichnet, dass der Keimschritt folgende Behandlungen enthält :

| | C1 | C2 | C3 |
|---|---|---|---|
| EINSCHUB-TEMPERATUR | 800°C | 850°C | 900°C |
| WÄRMEBE-HANDLUNG | Temperaturanstieg bis 900°C in 26 mn | Temperatur anstieg bis 900°C in 13 mn | Gleiche Temperatur 12 mn lang |
| ATMOS-PHÄRE | $O_2$ trocken 10 mn, dann $O_2$ trocken + 1 % HCl | $O_2$ trocken 10 mn, dann $O_2$ trocken + 1 % HCl | $O_2$ trocken 10 mn, dann $O_2$ trocken + 1 % HCl |

12

8. Verfahren gemäss Anspruch 6 oder 7, dadurch gekennzeichnet, dass der Schritt der Bildung der fehlerfreien Zone und der Konsolidierung der Keime folgende Behandlungen enthält :

| | |
|---|---|
| EINSCHUB-TEMPERATUR | 900°C |

| | |
|---|---|
| WÄRMEBE-HANDLUNG | 1. Temperaturanstieg bis 1100°C in 30 mn.<br>2. Beibehaltung der Temperatur von 1100°C 30 mn lang.<br>3. Beibehaltung der Temperatur von 1100°C 60 mn lang.<br>4. Temperaturrückgang auf 1000°C in 20 mn.<br>5. Temperaturrückgang auf 900°C in 20 mn. |

| | |
|---|---|
| ATMOS-PHÄRE | 1. und 2. $O_2$ trocken + 1 % HCl<br>3. und 4. $N_2/O_2/HCl$ im Verhältnis 97,5/1,5/1<br>5. $N_2$ |

9. Verfahren gemäss Anspruch 3, dadurch gekennzeichnet, dass für die Scheiben mit einer anfänglichen Sauerstoffkonzentration von über 40 ppmA der besagte Wärmeanpassungszyklus nur den Schritt der Bildung einer fehlerfreien Zone und der Konsolidierung der Keime in einer Temperatur von 1 050 bis 1 200 °C enthält.

10. Verfahren gemäss Anspruch 9, dadurch gekennzeichnet, dass für die Scheiben mit einer Anfangssauerstoffkonzentration von weniger als 26 ppmA der besagte Wärmanpassungszyklus einen Keimungsschritt in einer Temperatur von 800 bis 900° enthält, der ca. eine Stunde lang dauert, und einen Schritt der Bildung der fehlerfreien Zone und Konsolidierung der Keime in einer Temperatur von 1 050 und 1 200 °C.

11. Verfahren gemäss Anspruch 9 oder 10, dadurch gekennzeichnet, dass besagter Schritt der Bildung der fehlerfreien Zone und der Konsolidierung der Keime folgenden Zyklus enthält :

| | |
|---|---|
| EINSCHUB-TEMPERATUR | 900°C |

| | |
|---|---|
| WÄRMEBE-HANDLUNG | 1. Temperaturanstieg bis 1100°C in 30 mn.<br>2. Beibehaltung der Temperatur vcn 1100°C 30 mn lang.<br>3. Beibehaltung der Temperatur von 1100°C 60 mn lang.<br>4. Temperaturrückgang auf 1000°C in 20 mn.<br>5. Temperaturrückgang auf 900°C in 20 mn. |

| | |
|---|---|
| ATMOS-PHÄRE | 1. und 2. $O_2$ trocken + 1 % HCl<br>3. und 4. $N_2/O_2/HCl$ im Verhältnis 97,5/1,5/1<br>5. $N_2$ |

0 165 364

FIG.1

FIG.6

TRANCHES
FOURNISSEUR A

TRANCHES
FOURNISSEUR B

STOCKAGE
DES
TRANCHES

ETAPE
1

TRI
DES TRANCHES

ETAPE
2

C1

C2

C3

CYCLE D'ADAPTATION

GÉNÉRATION
DE
GERMES (a)

GÉNÉRATION
DE
GERMES (b)

GÉNÉRATION
DE
GERMES (c)

ETAPE
3

FORMATION
ZONE SANS
DEFAUT

FORMATION
ZONE SANS
DEFAUT

FORMATION
ZONE SANS
DEFAUT

ETAPE
4

NETTOYAGE
DES
TRANCHES

ETAPE
5

TRANCHES
UNIVERSELLES

FIG. 2

FIG.3

FIG. 4

0 165 364

4

FIG.5